# EUROPÄISCHE PATENTANMELDUNG

(11) **EP 1 341 262 A2**
(43) Veröffentlichungstag der Anmeldung: **03.09.2003**
(21) Anmeldenummer: 03004037.2
(22) Anmeldetag: 24.02.2003
(51) Int. Cl.: H01R 9/03

(54) **Verbindungsorgan für mehradrige elektrische Kabel**

(30) Priorität: 27.02.2002 DE 10208454
(71) Anmelder: Vif Videotechnik für Industrie + Forschung GmbH, 83646 Bad Tölz (DE)
(72) Erfinder: Böshenz, Ernst, 83646 Bad Tölz (DE)
(74) Vertreter: Manitz, Finsterwald & Partner GbR

(57) **Zusammenfassung**

Es wird ein Verbindungsorgan für mehradrige elektrische Kabel beschrieben, das gekennzeichnet ist durch eine flexible Platine mit einer Mehrzahl von sich von einem Platinenrandbereich zum gegenüberliegenden Platinenrandbereich erstreckenden elektrischen Leiterbahnen, deren Endbereiche als Lötpads ausgebildet sind, sowie zumindest ein zur Fixierung der mit den Kabeladern verbundenen Platine in einer Aufrollposition dienendes Schrumpfschlauchelement.

## Beschreibung

Die Erfindung betrifft ein Verbindungsorgan für mehradrige elektrische Kabel, insbesondere für miteinander zu verbindende Kabel unterschiedlicher Bauart bzw. unterschiedlicher mechanischer Eigenschaften.

In der Praxis kommt es häufig vor, dass mehradrige elektrische Kabel von unterschiedlichem Aufbau und damit auch unterschiedlicher Beanspruchbarkeit und insbesondere unterschiedlicher Flexibilität miteinander verbunden werden müssen. Dies ist beispielsweise bei in Robotern verwendeten Videokabeln der Fall, die im Betrieb hohen Beanspruchungen durch Biegevorgänge ausgesetzt sind und demgemäß entsprechend stabil ausgebildet sein müssen, während außerhalb der Maschine bzw. des Roboters gegebenenfalls über längere Strecken geführte Standardkabel geringeren Durchmessers eingesetzt werden.

Zur Verbindung derartiger unterschiedlicher Kabel ist es bekannt, speziell gebaute Verbindungsgeräte zu verwenden, in denen im Regelfall aus Koaxialleitern bestehenden Videoleiter sowie die ebenfalls im Kabel vorhandenen Steuerleitungen gegebenenfalls unter Verwendung von Zwischenelementen miteinander verlötet werden. Solche Verbindungsgeräte, die die Form von beispielsweise quaderförmigen Dosen haben können, stellen aber im Gesamtkabelverlauf aufgrund ihres Volumens und ihres Gewichts ein ausgesprochen störendes Gebilde dar, das überdies im Langzeitbetrieb gerade aufgrund seines Gewichts und Volumens wiederum Ursache für Störungen sein kann.

Aufgabe der Erfindung ist es daher, ein Verbindungsorgan der eingangs angeführten Art zu schaffen, das einerseits eine einfache Herstellung der Verbindung zwischen den Kabeln unterschiedlicher Art ermöglicht und andererseits sich durch geringes Volumen auszeichnet, so dass sich das Verbindungsorgan unter Sicherstellung der geforderten mechanischen und elektrischen Eigenschaften harmonisch in den Gesamtkabelverlauf einfügt.

Gelöst wird diese Aufgabe nach der Erfindung im wesentlichen durch eine flexible Platine mit einer Mehrzahl von sich von einem Randbereich der Platine zum gegenüberliegenden Randbereich erstreckenden Leiterbahnen, deren Endbereiche als Lötpads zum Anschluss der Adern der miteinander zu verbindenden Kabel ausgebildet sind, sowie zumindest einem Umschließungsorgan zur Fixierung der mit den Kabeladern verbundenen Platine in einer Aufrollposition.

Wesentlich für die erfindungsgemäß Lösung ist somit die Verwendung einer zunächst ebenen flexiblen Platine, mit deren Anschlusspads die Adern bzw. Leitungen der miteinander zu verbindenden Kabeln verlötet werden können, worauf ein vorzugsweise um einen Wickelkern erfolgendes Aufrollen der mit den Adern der Kabel verlöteten Platine erfolgt und die aufgerollte Platine vorzugsweise mittels eines Schrumpfschlauchs in der Aufrollposition unter gleichzeitiger Zugentlastung der Kabeladern fixiert wird.
Auf diese Weise gelingt es, einerseits die Verlötung der Kabeladern mit den Lötpads auf der flexiblen Platine in deren ebenem Zustand extrem zu vereinfachen und andererseits diese Platine mit den angeschlossenen Kabeladern in einen kleinvolumigen Rollzustand zu überführen und in diesem Zustand so zu fixieren, dass sich das so geschaffene Verbindungsorgan optimal in den Kabelverlauf einfügt.

Besonders vorteilhafte Ausgestaltungen der Erfindung sind in den Unteransprüchen angegeben und werden in der nachfolgenden Beschreibung von Ausführungsbeispielen unter Bezugnahme auf die Zeichnung näher erläutert. In der Zeichnung zeigt:
- Fig. 1: eine Draufsicht auf eine gemäß der Erfindung ausgebildete flexible Platine,
- Fig. 2: einen Vertikalschnitt durch einen Anschlussbereich der flexiblen Platine nach Fig. 1 mit angelöteten Kabeladern,
- Fig. 3: eine vergrößerte Teilschnittdarstellung der flexiblen Platine mit verlöteter Kabelader,
- Fig. 4: eine schematische Darstellung zur Erläuterung der Aufrollposition eines Verbindungsorgans nach der Erfindung und
- Fig. 5: eine schematische Darstellung einer zur Ausbildung eines Kabelverteilers geeigneten Platine nach der Erfindung.

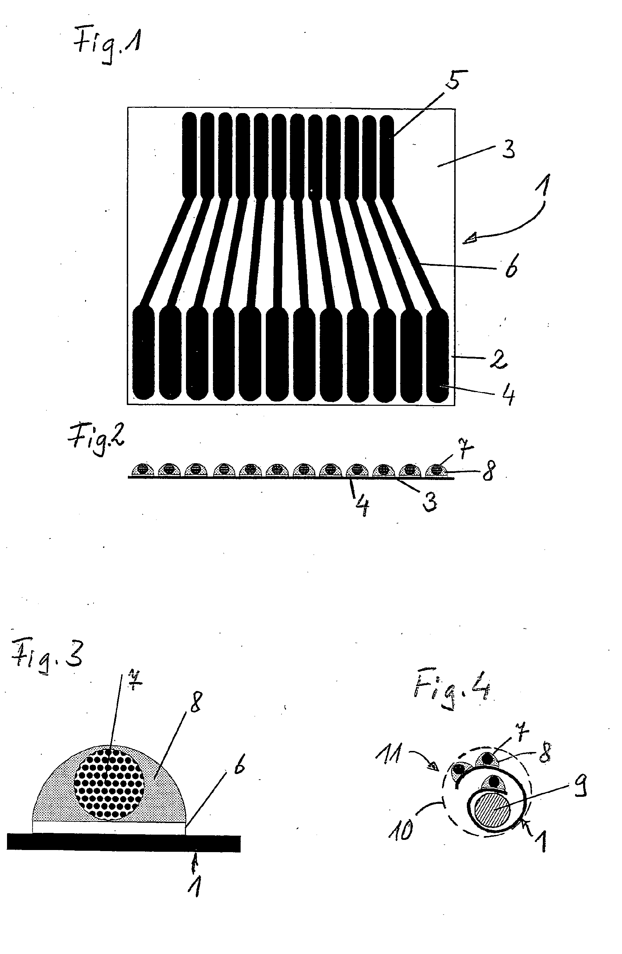

Fig. 1 zeigt ein Beispiel einer rechteckigen flexiblen Platine 1 mit in bekannter Weise darauf angebrachten Leiterbahnen 6, die sich zwischen in einander gegenüberliegenden Randbereichen 2, 3 in analoger Weise zu den Leiterbahnen ausgebildeten Lötpads 4, 5 erstrecken.

In den Aufbau der flexiblen Platine 1, die von einer ein- und mehrlagigen Struktur sein kann, lässt sich auch ein insbesondere netzartig strukturiertes Abschirmmaterial integrieren.

Die in den einander gegenüberliegenden Randbereichen 2, 3 vorgesehenen Lötpads 4, 5 sind im dargestellten Ausführungsbeispiel langgestreckt und parallel zueinander ausgebildet, wobei die Größe der Lötpads 4, 5 in den beiden Randbereichen 2, 3 unterschiedlich ist. Während im ersten Randbereich 2, wo sich die flächenmäßig größeren Lötpads 4 befinden, die Adern eines stabileren und auch größeren Durchmesser besitzenden Kabels angeschlossen bzw. verlötet werden, sind die schmäleren Lötpads 5 des zweiten Randbereichs 3 zur Verlötung mit den Adern eines beispielsweise mit einem konventionellen Videostecker verbundenen dünneren Standard-Kabels bestimmt. Im Falle des Vorhandenseins von Koaxialleiteradern werden Innenleiter und Schirmung jeweils mit zwei unmittelbar benachbarten Lötpads verbunden, was im Hinblick auf die Kompaktheit des Verbindungsorgans ohne Funktionseinbußen möglich ist.

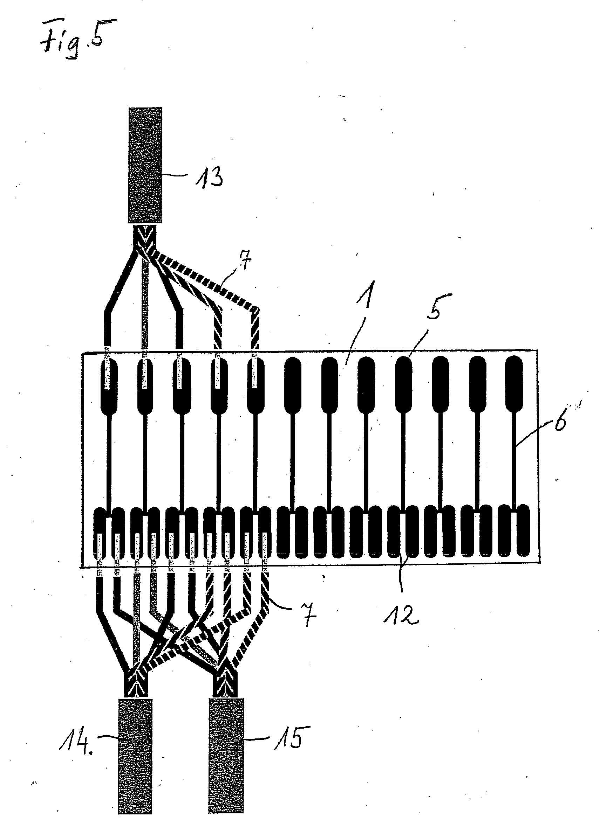

Fig. 2 zeigt einen Vertikalschnitt durch die im ersten Randbereich 2 gelegenen Lötpads 4 nach deren Verlötung mit den Adern eines stabilen Kabels, wie es beispielsweise in Robotern verwendet wird und dabei einer extrem großen Zahl von Biegebelastungen standhalten muss.
Das Verlöten dieser Adern mit den Lötpads ist problemfrei möglich, da sich bei diesem Vorgang des Verlötens die flexible Platine in einem ebenen Zustand befindet.

Die Teilschnittdarstellung nach Fig. 3 zeigt einen Ausschnitt der flexiblen Platine 1 mit sich darauf befindender Leiterbahn 6 und einer Kabellader 7, die über Lötzinn 8 elektrisch leitend und stabil mit der Leiterbahn 6 verbunden ist.

Wenn alle Adern bzw. Leitungen der miteinander zu verbindenden Kabel mit den entsprechenden Lötpads 4, 5 auf der Platine 1 verlötet und somit die elektrischen Verbindurigen zwischen Kabeln hergestellt sind, wird die flexible Platine 1 um einen Wickelkern 9 gewickelt, wie dies in Fig. 4 schematisch dargestellt ist. In der Aufrollposition 11 wird zur Schaffung des fertigen Verbindungsorgans über die aufgerollte Platine ein Schrumpfschlauchabschnitt geschoben, und mittels dieses Schrumpfschlauches, der bei Wärmeeinwirkung seinen Durchmesser verringert, erfolgt die endgültige Fixierung des Verbindungsorgans zwischen den beiden miteinander verbundenen Kabeln. Der Schrumpfschlauch erstreckt sich vorzugsweise auch noch über die jeweiligen Kabelenden, so dass einerseits ein praktisch kontinuierlicher und einwandfrei geschützter Übergang zwischen den beiden Kabelenden realisiert und andererseits gleichzeitig eine Zugentlastung für die Adern der miteinander verbundenen Kabeln geschaffen wird.

Fig. 5 zeigt die Ausgestaltung eines erfindungsgemäßen Verbindungsorgans als Kabelverteiler. Die Adern eines Eingangskabels werden dabei über das Verbindungsorgan mit den entsprechenden Adern 7 zweier Ausgangskabel 14, 15 verbunden, wobei in diesem Fall - obwohl dies nicht unbedingt notwendig ist - zum Zwecke der Vereinfachung der Durchführung der Lötvorgänge ausgangsseitig auf der flexiblen Platine 1 Doppel-Lötpads 12 vorgesehen sind.

Die lang gestreckt rechteckige ausgebildete flexible Platine 1 trägt ein regelmäßiges Muster von Leiterbahnen 6 und Lötpads 4, 5, 12, wobei gemäß diesem Beispiel nicht alle Lötpads belegt sind. Dies zeigt, dass die flexible Platine gemäß der Erfindung auch als Bauteil mit einer bestimmten Standardgröße ausgeführt sein kann und damit eine einfache Ablängung dieses Standardbauteils entsprechend den jeweiligen Gegebenheiten durchführbar ist.

### Bezugszeichenliste

- 1: Flexible Platine
- 2: erster Randbereich
- 3: zweiter Randbereich
- 4: Lötpad
- 5: Lötpad
- 6: Leiterbahn
- 7: Kabelader (Draht)
- 8: Lötzinn
- 9: Wickelkern
- 10: Umwicklungselement
- 11: Aufrollposition
- 12: Doppel-Lötpad
- 13: Eingangskabel
- 14: Ausgangskabel
- 15: Ausgangskabel

## Patentansprüche

1. Verbindungsorgan für mehradrige elektrische Kabel, insbesondere für miteinander zu verbindende Kabel unterschiedlicher Bauart bzw. unterschiedlicher mechanischer Eigenschaften,
**gekennzeichnet durch**
eine flexible Platine (1) mit einer Mehrzahl von sich von einem ersten Randbereich (2) der Platine (1) zum gegenüberliegenden zweiten Randbereich (3) erstreckenden elektrischen Leiterbahnen (6), deren Endbereiche als Lötpads (4, 5) zum Anschluss der Adern (7) der miteinander zu verbindenden Kabel ausgebildet sind, sowie zumindest ein Umschließungselement (10) zur Fixierung der mit den Kabeladern (7) verbundenen Platine (1) in einer Aufrollposition (11).

2. Verbindungsorgan nach Anspruch 1,
**dadurch gekennzeichnet,**
**dass** die flexible Platine (1) in der Aufrollposition (11) um einen Wickelkern (9) aus elektrisch isolierendem Material gewickelt ist.

3. Verbindungsorgan nach Anspruch 2,
**dadurch gekennzeichnet,**
**dass** der Wickelkern (9) aus einem zylindrischen Voll- oder Hohlstab besteht.

4. Verbindungsorgan nach Anspruch 2,
**dadurch gekennzeichnet,**
**dass** der Wickelkern (9) aus einem konischen Teil aus elektrisch isolierendem Voll- oder Hohlmaterial besteht.

5. Verbindungsorgan nach Anspruch 1,
**dadurch gekennzeichnet,**
**dass** in die flexible Platine (1) eine elektrische Abschirmfunktion besitzendes Material integriert ist.

6. Verbindungsorgan nach einem der vorhergehenden Ansprüche,
**dadurch gekennzeichnet,**
**dass** die flexible Platine (1) mehrlagig ausgebildet ist.

7. Verbindungsorgan nach einem der vorhergehenden Ansprüche,
**dadurch gekennzeichnet,**
**dass** die auf der flexiblen Platine (1) ausgebildeten Leiterbahnen (6) von dem ersten Randbereich (2) zum gegenüberliegenden zweiten Randbereich (3) in ihrer Gesamtheit zueinander parallel oder divergierend verlaufen, wobei die Größe der Lötpads (4) in den beiden Randbereichen (2, 3) zumindest zum Teil unterschiedlich sein kann.

8. Verbindungsorgan nach Anspruch 7,
**dadurch gekennzeichnet,**
**dass** in beiden Randbereichen (2, 3) langgestreckte, parallel zueinander angeordnete Lötpads (4, 5) vorgesehen sind.

9. Verbindungsorgan nach einem der vorhergehenden Ansprüche,
**dadurch gekennzeichnet,**
**dass** die Aufrollachse der flexiblen Platine (1) zumindest im wesentlichen parallel zur Längserstreckung der Lötpads (4, 5) verläuft.

10. Verbindungsorgan nach Anspruch1,
**dadurch gekennzeichnet,**
**dass** als Umschließungselement (10) ein Schrumpfschlauchabschnitt vorgesehen ist.

11. Verbindungsorgan nach Anspruch 10,
**dadurch gekennzeichnet,**
**dass** der Schrumpfschlauchabschnitt (10) die aufgerollte Platine (1) sowie die Endbereiche der miteinander verbundenen Kabel umschließt und eine Zugentlastung für die Kabeladern bildet.

12. Verbindungsorgan nach einem oder mehreren der vorhergehenden Ansprüche,
**dadurch gekennzeichnet,**
**dass** zur Ausbildung eines Verteilers die Lötpads (4) des ersten Randbereichs der Platine (1) mit den Adern eines Eingangskabels (13) und die Lötpads (12) des gegenüberliegenden Randbereichs mit den Adern von wenigstens zwei Ausgangskabeln (14, 15) verbunden sind.

13. Verbindungsorgan nach Anspruch 12,
**dadurch gekennzeichnet,**
**dass** in dem den beiden Ausgangskabeln (14, 15) zugeordneten Randbereich jeder Leiterbahn (6) ein Doppel-Lötpad (12) zugeordnet ist.

14. Verbindungsorgan nach einem der vorhergehenden Ansprüche,
**dadurch gekennzeichnet,**
**dass** die Lötpads (5) eines Randbereichs der Platine (1) in einem Vorkonfektionierungsschritt bereits mit den Adern eines mit einem Stecker- oder Buchsenteil verbundenen Kabelabschnitts verlötet sind.

15. Verbindungsorgan nach einem der vorhergehenden Ansprüche,
**dadurch gekennzeichnet,**
**dass** bei Kabeln mit Koaxialleiteradern der Innenleiter und die Schirmung mit jeweils benachbarten Lötpads verbunden sind.

16. Verbindungsorgan nach einem der vorhergehenden Ansprüche,
**dadurch gekennzeichnet,**
**dass** die lang gestreckt rechteckig ausgebildete flexible Platine (1) ein regelmäßiges Muster von Leiterbahnen (6) und Lötpads (4, 5, 12) trägt und in Abhängigkeit von der Anzahl der Adern der zu verbindenden Kabel ablängbar ist.

17. Kabelanordnung, bestehend aus zumindest zwei miteinander verbundenen mehradrigen elektrischen Kabeln, insbesondere Kabeln mit mechanisch unterschiedlichem Aufbau,
**gekennzeichnet durch**
eine Verbindung dieser Kabel nach einem oder mehreren der vorhergehenden Ansprüche.
